**Europäisches Patentamt**

**European Patent Office**

**Office européen des brevets**

(19)

(11) Veröffentlichungsnummer: **0 025 210**
**B1**

(12) **EUROPÄISCHE PATENTSCHRIFT**

(45) Veröffentlichungstag der Patentschrift:
03.09.86

(51) Int. Cl.⁴: **H 01 L 23/56,** G 11 C 17/00

(21) Anmeldenummer: **80105239.0**

(22) Anmeldetag: **03.09.80**

(54) **Schutzkappe.**

(30) Priorität: **11.09.79 DE 2936615**

(43) Veröffentlichungstag der Anmeldung:
**18.03.81 Patentblatt 81/11**

(45) Bekanntmachung des Hinweises auf die Patenterteilung:
**03.09.86 Patentblatt 86/36**

(84) Benannte Vertragsstaaten:
**AT BE CH FR GB IT LI NL SE**

(56) Entgegenhaltungen:
**DE-A-2 032 402**
**FR-A-2 271 669**
**US-A-3 684 817**

(73) Patentinhaber: **BROWN, BOVERI & CIE**
**Aktiengesellschaft Mannheim, Kallstadter**
**Strasse 1, D-6800 Mannheim Käfertal (DE)**

(72) Erfinder: **Ermert, Ingo, Am Landgraben 1, D-6836**
**Oftersheim (DE)**

(74) Vertreter: **Kempe, Wolfgang, Dr., c/o Brown,**
**Boveri & Cie AG Postfach 351, D-6800 Mannheim**
**1 (DE)**

EP 0 025 210 B1

## Beschreibung

Die Erfindung bezieht sich auf eine Schutzkappe für einen integrierten Festkörperschaltkreis in einem DIL-Gehäuse, insbesondere für einen löschbaren, programmierbaren Halbleiterfestwertspeicher (EPROM) mit einem Fenster an der Oberseite des DIL-Gehäuses.

Integrierte Festkörperschaltkreise sind sehr oft in einem DIL-Gehäuse (dual-in-line-Gehäuse) untergebracht. Die elektrischen Anschlüsse sind an den beiden Längsseiten hintereinander angeordnet und meistens als Kontaktbeine rechtwinklig nach unten abgebogen. Die über das Gehäuse frei hinausragenden Kontaktbeine sind hierdurch für mechanische Beschädigungen relativ anfällig.

Es sind Maßnahmen bekanntgeworden, DIL-Gehäuse mit ihren Kontaktbeinen in ein entsprechend zurechtgeschnittenes Stück Schaumstoff zu stecken, in dem sie für den Transport und bis zur endgültigen Montage verbleiben.

Es ist weiterhin bekannt, gegen ungewölltes Löschen des Speicherinhalts durch Tages- bzw. künstliches Licht, die Fenster mit einem lichtundurchlässigen Klebestreifen zu verscklließen.

Es hat sich gezeigt, daß die beiden vorgenannten Maßnahmen in ihrer Wirksamkeit ungenügend und von ihrer Anwendung her relativ umständlich sind.

Aus der US-PS 36 84 817 ist eine Schutzkappe für einen integrierten Festkörperschaltkreis bekannt, die an allen vier Seiten keilförmige Ausformungen aufweist. Die Ausformungen an der Schmalseite sind dabei mit einer speziellen Schnappvorrichtung ausgebildet. Diese Abdeckung ist sehr aufwendig ausgeführt, sie gibt keinen absoluten Schutz vor Lichteinwirkung und bietet keine Abdeckung der seitlichen Kontaktbeine.

Der Erfindung liegt deshalb die Aufgabe zugrunde, mit einfachen Mitteln eine Schutzkappe zu schaffen, welche einen mechanischen Schutz für die Kontaktbeine gewährleistet und einen ungewollten Lichteinfall durch das Fenster des DIL-Gehäuses verhindert.

Diese Aufgabe wird erfindungsgemäß durch die Merkmale des Patentanspruchs gelöst. Ausgestaltungen sind aus den Unteransprüchen ersichtlich.

Die mit der Erfindung erzielten Vorteile bestehen insbesondere darin, daß mit der Schutz- bzw. Deckkappe auf einfache Art und Weise die Kontaktbeine sicher gegen mechanische Beschädigung geschützt sind und gleichzeitig das Fenster lichtdicht verschlossen ist. Desweiteren bilden das DIL-Gehäuse und die Schutzkappe eine Funktionseinheit, d.h. die Schutzkappe verbleibt ständig auf dem DIL-Gehäuse und wird nur zum Löschen des Speicherinhalts abgezogen. Das DIL-Gehäuse kann also mit aufgeschnappter Schutzkappe in die Fassung gesteckt bzw. aus dieser wieder entfernt werden.

Ein Ausführungsbeispiel der Erfindung ist in der Zeichnung dargestellt und wird im folgenden näher beschrieben.

Es zeigen:

Fig. 1 einen elektronischen Baustein mit einer an seiner Stirnseite angeordneten IC-Fassung;

Fig. 2 einen integrierten Festkörperschaltkreis in einem DIL-Gehäuse;

Fig. 3 eine Schutzkappe für das in Figur 2 gezeigte DIL-Gehäuse;

Fig. 4 im Detail eine Rastzunge der in Figur 3 dargestellten Schutzkappe;

Fig. 5 eine Ansicht von der Unterseite der Schutzkappe;

Fig. 6 eine Ansicht im Schnitt in der Ebene VI - VI der Schutzkappe nach Fig. 5.

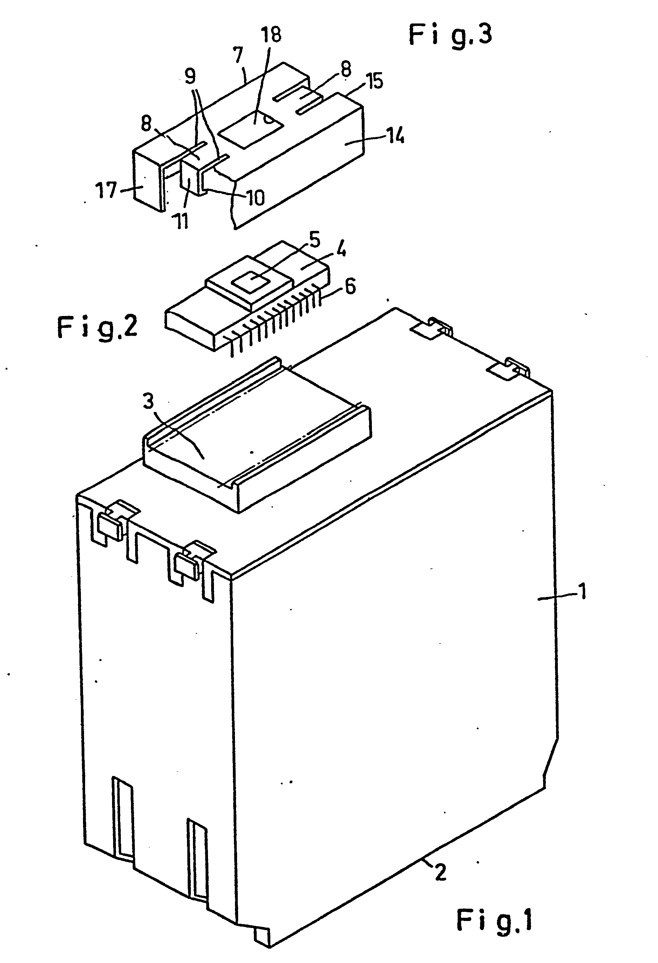

Der Figur 1 ist ein elektronischer Baustein 1 zu entnehmen, der mit seiner Unterseite 2 auf einer nicht näher dargestellten Hutprofilschiene befestigt wird. An der Stirnseite des Elektronik-Bausteins 1 ist eine Fassung 3 angeordnet für einen löschbaren, programmierbaren Halbleiterfestwertspeicher (EPROM) in einem DIL-Gehäuse 4. An der Oberseite des DIL-Gehäuses befindet sich ein Fenster 5, durch welches z.B. mit Hilfe von UV-Licht der Speicherinhalt gelöscht werden kann. An den beiden Längsseiten sind rechtwinklig nach unten abgebogene Kontaktbeine 6 angeordnet. Auf das DIL-Gehäuse ist eine Schutzkappe 7 aus lichtundurchlässigem Plast aufschnappbar.

Die Schutzkappe entspricht etwa einer quaderförmigen, offenen Schachtel. Die beiden Stirnseiten der Schutzkappe sind mit Rastelementen versehen, die als Rastzungen 8 ausgebildet sind durch jeweils zwei von der Stirnseite zur Mitte hin verlaufende Schlitze 9 sowie jeweils durch einen sich daran anschliessenden, rechtwinklig nach unten verlaufenden freien Schenkel 11, mit einer einwärtsgebogenen Rastnase 10 gebildet werden. Wird die Schutzkappe 7 auf das DIL-Gehäuse 4 aufgeschnappt, hintergreifen die Rastnasen 10 das DIL-Gehäuse an seiner Unterseite.

Zum leichteren Lösen der Verrastung kann an den Außenseiten der Schenkel 11, etwa in Höhe der Rastnase 10, ein in der Zeichnung nicht näher dargestellter Mitnehmer angeformt sein.

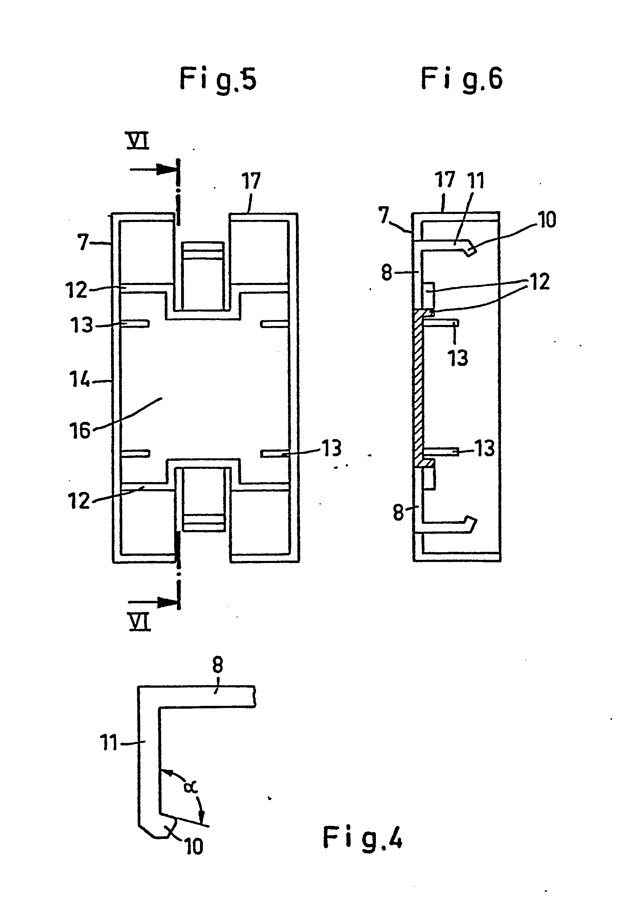

Durch den von dem freien Schenkel 11 und der Rastnase 10 gebildeten stumpfen Winkel ($\alpha$) (Fig. 4) wird erreicht, daß die aufgeschnappte Schutzkappe 7 spielfrei auf dem DIL-Gehäuse 4 sitzt. Zur genauen Auflage des DIL-Gehäuses in der Schutzkappe sind auf der Bodeninnenseite Stege 12 angeordnet. Die Innenseiten der Schutzkappe weisen Anformungen 13 auf, welche zur Arretierung des DIL-Gehäuses zwischen die Kontaktbeine 6 ragen. Die Schutzkappe ist auf ihrer Oberseite mit einer Markierung 18 versehen zum seitenrichtigen Einsetzen des DIL-Gehäuses 4 in die Fassung 3. Die Markierung kann beispielsweise durch eine aufgeklebte Folie, oder durch einen Siebdruck hergestellt werden.

## Patentansprüche

1. Schutzkappe mit zwei Seitenwänden und zwei Stirnseiten für einen integrierten Festkörperschaltkreis, insbesondere für einen löschbaren, programmierbaren Halbleiterfestwertspeicher (EPROM), welche auf ein DIL-Gehäuse aufschnappbar ist, deren Seitenwände (14) die Kontaktbeine (6) des DIL-Gehäuses (4) abdecken, welche das Fenster (5) auf dem DIL-Gehäuse lichtdicht abschließt und welche an ihren beiden Stirnseiten (15, 17) eine Rastzunge (8) aufweist, die durch jeweils zwei von den Stirnseiten (15, 17) der Schutzkappe (7) zur Mitte hin verlaufenden Schlitzen (9) gebildet wird und die einen rechtwinklig nach unten verlaufenden freien Schenkel (11) mit einer einwärtsgebogenen Rastnase (10) aufweist.

2. Schutzkappe nach Anspruch 1, dadurch gekennzeichnet, daß auf der Bodeninnenseite Stege (12) zur Auflage des DIL-Gehäuses (4) angeordnet sind.

3. Schutzkappe nach Anspruch 1, dadurch gekennzeichnet, daß die Innenseiten der Schutzkappe Anformungen (13) aufweisen, welche zur Arretierung des DIL-Gehäuses zwischen die Kontaktbeine (6) ragen.

## Claims

1. Protective cap which has two side walls and two end faces for an integrated solid state circuit, in particular for a semiconductor erasable programmable read-only memory (EPROM) and which can be snapped on to a dual-in-line package and the side walls (14) of which cover the contact pins (6) of the dual-in-line package (4) and which closes the window (5) on the dual-in-line package in a light-tight manner and which at its two end faces (15, 17) exhibits a locking tongue (8), which is formed by two respective slits (9) extending from the end faces (15, 17) of the protective cap (7) towards the centre and which exhibits a free limb (11), which extends downwardly at right angles, with an inwardly bent detent (10).

2. Protective cap according to Claim 1, characterized in that webs (12) for supporting the dual-in-line package (4) are disposed upon the internal surface of the floor.

3. Protective cap according to Claim 1, characterized in that the internal surfaces of the protective cap exhibit formations (13) which project between the contact pins (6) to lock the dual-in-line package.

## Revendications

1. Couvercle de protection à deux parois latérales et deux faces frontales pour un circuit intégré à semiconducteurs, en particulier pour une mémoire morte programmable et effaçable à semiconducteurs (EPROM), qui peut être encliqueté sur un boîtier DIL, dont les parois latérales (14) recouvrent les contacts (6) du boîtier DIL (4), qui ferme de façon étanche à la lumière la fenêtre (5) du boîtier DIL et qui comporte sur chacune de ses deux faces frontales (15, 17) une languette d'encliquetage (8) qui est formée par deux fentes (9) allant des faces frontales (15, 17) du couvercle de protection (7) vers le milieu et qui présente une branche libre (11) dirigée à angle droit vers bas et munie d'un bec d'encliquetage (10) recourbé vers l'intérieur.

2. Couvercle de protection selon la revendication 1, caractérisé par le fait que sur la face interne du fond sont disposées des traverses (12) servant d'appui au boîtier DIL (4).

3. Couvercle de protection selon la revendication 1, caractérisé par le fait que les faces internes du couvercle de protection comportent des appendices (13) qui, pour le blocage du boîtier DIL, pénètrent entre les contacts (6).

Fig.3

Fig.2

Fig.1

## Fig.5

## Fig.6

## Fig.4